# EUROPÄISCHE PATENTANMELDUNG

(11) **EP 3 629 687 A1**
(43) Veröffentlichungstag der Anmeldung: **01.04.2020**
(21) Anmeldenummer: 18196877.7
(22) Anmeldetag: 26.09.2018
(51) Int. Cl.: H05K 7/20

(54) **VERFAHREN FÜR EINE MONTAGE EINES ELEKTRISCHEN GERÄTS**

(71) Anmelder: Siemens Aktiengesellschaft, 80333 München (DE)
(72) Erfinder: Petricek, Martin, 2020 Hollabrunn (AT); Draschkowitz, Günter, 1220 Wien (AT); Emberger, Andreas, 1030 Wien (AT)
(74) Vertreter: Maier, Daniel Oliver

(57) **Zusammenfassung**

Die Erfindung betrifft ein Verfahren zur Montage eines elektrischen Geräts (1), welches aus auf einer Trägerplatte (8) angebrachten Bauelementen (9, 10) aufgebaut ist. Von zumindest einem Bauelement (9) wird eine Verlustleistung produziert, welche über eine thermische Verbindung zu einem Kühlkörper (2) abgeleitet wird. Vom erfindungsgemäßen Montageverfahren umfasst dabei zumindest folgenden Schritte:
a. Bereitstellen zumindest des Kühlkörpers (2) mit zumindest einem vormontierten Befestigungskörper (3) und einer Isolierung (4) mit zumindest einer Isolierhülse (5), wobei eine Position des Befestigungskörpers (3) auf dem Kühlkörper (2) sowie eine Position der Isolierhülse (5) auf der Isolierung (4) durch eine Position des zumindest einen zu kühlenden Bauelements (9) auf der Trägerplatte (8) vorgegeben werden (100);
b. Anbringen der Isolierung (4) auf dem Kühlkörper (2) derart, dass der zumindest eine Befestigungskörper (3) in die zumindest eine Isolierhülse (5) eingefügt wird (110) ;
c. Anbringen der Trägerplatte (8) bzw. des Geräts (1) auf der Isolierung (4) derart, dass der in die Isolierhülse (5) eingefügte Befestigungskörper (3) in einen Auslass (11) in der Trägerplatte (8) eingebracht wird, wobei eine Position des Auslasses (11) in der Trägerplatte (8) durch die Position des zumindest einen zu kühlenden Bauelements (9) vorgegeben wird (120);
d. Anbringen des Anpresselements (12) auf dem zumindest einen Befestigungskörper (3) (130); und
e. Verbinden des Anpresselements (12) mit dem Befestigungskörper (3) derart, dass das zumindest eine zu kühlende Bauelement (9) über die Trägerplatte (8) und die Isolierung (4) mit dem Kühlkörper (2) verspannt wird (140).

## Beschreibung

### Technisches Gebiet

Die vorliegende Erfindung betrifft allgemein das Gebiet elektrischer und elektronischer Geräte, insbesondere den Bereich der Schaltnetzteile sowie der leistungselektronischen Schaltungen. Im Speziellen bezieht sich die vorliegende Erfindung auf ein Verfahren zur Montage eines elektrischen Geräts, insbesondere Schaltnetzteil und/oder leistungselektronische Schaltung, welches aus auf einer Trägerplatte angeordneten Bauelementen und/oder Bauelementgruppen aufgebaut ist. Dabei wird von zumindest einem Bauelement eine Verlustleistung (z.B. in Form von Wärme) produziert, welche über eine thermische Verbindung zu einem Kühlkörper abgeleitet wird.

### Stand der Technik

Geräte, insbesondere elektrische oder elektronische Geräte wie z.B. Schaltnetzteile, leistungselektronische Schaltungen, Steuergeräte, etc. werden heutzutage üblicherweise aus elektrischen Bauelementen und/oder Bauelementgruppen aufgebaut. Die Bauelemente sind dabei auf einer Trägerplatte - einer so genannte Leiterplatte - anbracht, welche einer mechanische Befestigung sowie über so genannte Leiterbahnen einer elektrischen Verbindung der Bauelemente dient. Die Bauelemente können z.B. mittels Anlöten auf Lötflächen oder in Lötaugen, mittels Aufkleben, etc. und bei größeren Bauelementen mittels Verschraubung auf der Leiterplatte befestigt werden.

Häufig umfassen Schaltungen für elektrische und/oder elektronische Geräte Halbleiterbauelemente (z.B. Leistungshalbleiterelemente, etc.), von welchen eine meist thermische Verlustenergie - d.h. Wärme - produziert wird. Um beispielsweise eine Beschädigung oder ein Überhitzen des jeweiligen Bauelements oder der Schaltung bzw. eine Funktionsstörung des Geräts durch die produzierte Verlustleistung oder Wärme zu verhindern, ist es notwendig, die Verlustleistung oder Wärme über eine thermische Verbindung abzuleiten. D.h. die Verlustleistung bzw. Wärme produzierenden Bauelemente müssen entsprechend gekühlt und die produzierte Wärme abgeleitet werden.

Üblicherweise werden zum Ableiten der Wärme bzw. zum Kühlen eines Bauelements Wärme ableitende Teile - so genannte Kühlkörper - eingesetzt. Vom Kühlkörper, welcher üblicherweise aus einem gut wärmeleitfähigem Metall, meist Aluminium oder Kupfer besteht, wird eine so genannte Wärmebrücke gebildet, um die entstandene Wärme vom zu kühlenden Bauelement weg zu leiten und z.B. an eine Geräteumgebung abzugeben. Kühlkörper finden beispielsweise in der Leistungselektronik, in Steuergeräten, etc. vor allem zur Kühlung von Leistungshalbleitern (z.B. Leistungsdioden, Leistungstransistoren, etc.) Verwendung.

Im Bereich der Leistungselektronik wurden und werden beispielsweise sehr häufig so genannte bedrahtete Bauelemente verwendet. Ein bedrahtetes Bauelemente weist dabei Drahtanschlüsse - so genannte "Beinchen" - auf, welche durch Kontaktlöcher in der Trägerplatte gesteckt und anschließend z.B. mittels Löten mit der Trägerplatte verbunden werden. Für eine Kühlung wurden die Bauelemente beispielsweise mit einem Kühlkörper verbunden bzw. auf diesem angebracht, wobei die Bauelemente z.B. eine bessere thermische Verbindung mit einer Wärmeleitpaste bestrichen wurden. Die Bauelemente bildeten dann z.B. mit dem jeweiligen Kühlkörper eine eigene gekühlte Bauelementgruppe, welche auf der Trägerplatte angebracht bzw. ausgelötet werden könnte. Ein Nachteil bei dieser Vorgehensweise bestand vor allem darin, dass sowohl eine Montage des bedrahteten Bauelements wie der gekühlten Bauelementgruppe üblicherweise vorwiegend manuell bzw. nur halbautomatisiert durchgeführt werden kann bzw. könnte. D.h. der Montagevorgang von bedrahteten Bauelemente sowie die Montage von zugehörigen Kühlkörpern ist damit nicht durchgängig automatisierbar und damit wenig zeiteffizient und mit zusätzlichen Kosten verbunden.

Mit der Entwicklung von so genannten oberflächenbestückbaren bzw. Surface Mounted Device (SMD)-Varianten für Halbleiterbauelemente können z.B. auch Leistungsbauelemente flächig auf einer Trägerplatte aufgelötet werden. Über so genannte "Thermal vias" bzw. über Durchkontaktierungen können Verlustleistung bzw. Wärme produzierende Bauelemente beispielsweise thermisch gut an die Trägerplatte angebunden und ein Wärmetransport senkrecht zur Leiterplatte verbessert werden. Thermal vias sind dabei Durchkontaktierungen - d.h. eine vertikale, gegebenenfalls auch elektrische Verbindung in Form einer von innen metallisierten Bohrung in der Träger- bzw. Leiterplatte, deren primäre Aufgabe in einer Verbesserung der Wärmeableitung besteht. Damit ist beispielsweise eine relativ gute Wärmeabfuhr über eine Seite der Trägerplatte möglich, welche zumindest im Bereich von Verlustleistung produzierenden bzw. zu kühlenden Bauelementen - d.h. in einem Kühlbereich - keine Bestückung mit Bauelementen aufweist. Ein Kühlkörper zum Entwärmen eines Bauelements kann daher auch auf dieser Seite der Trägerplatte (z.B. Unterseite der Trägerplatte) angeordnet sein.

Um die Wärmeableitung zu begünstigen, benötigen Kühlkörper eine gute thermische Anbindung an das jeweils zu kühlende Bauelement. Daher ist es notwendig, einen möglichst engen und guten Kontakt zwischen dem Kühlkörper und dem zu kühlenden Bauelement herzustellen. Zum Ausgleich von Unebenheiten z.B. zwischen der Unterseite der Trägerplatte und einer Oberfläche des Kühlkörpers und um einen besseren Wärmeübergang zum Kühlkörper herzustellen, kann vor der Montage z.B. eine dünne Schicht Wärmeleitpaste aufgetragen werden. Bei einer elektrisch isolierenden Montage können beispielsweise eine elektrisch isolierende Schicht und/oder Isolierung zum Ausgleichen von Unebenheiten und zur Verbesserung der Wärmeübertragung genutzt werden.

Um den entsprechend engen und guten thermischen Kontakt zwischen dem zu kühlenden Bauelement und dem Kühlkörper herzustellen, wird das Bauelement üblicherweise auch gegen den Kühlkörper gepresst. Dazu können z.B. Federbleche eingesetzt werden, welche beispielsweise auf den zu kühlenden Bauelementen angeordnet und mittels Schrauben oder Klammern befestigt werden. Die Federbleche bewirken dann z.B. eine Anpresskraft, welche die Bauelemente gegen die Trägerplatte und damit gegen den an der Unterseite der Trägerplatte angeordneten Kühlkörper presst. Die Verwendung von Federblechen zum Anpressen von Bauelementen weist allerdings den Nachteil auf, dass eine Montage meist manuell durchgeführt werden muss und mit relativ großem Aufwand verbunden ist.

Insbesondere bei elektrischen Geräten (z.B. Schaltnetzteilen, leistungselektronischen Schaltungen) sind zusätzlich vorgegebene Spannungsabstände bzw. Mindestabstände für so genannte Luft- und Kriechstrecken zwischen leitenden Teilen in der Schaltung z.B. aus Sicherheits- und/oder funktionstechnischen Gründen zu berücksichtigen. Daher sind vor allem bei einer Entwärmung bzw. thermischen Verbindung zwischen zu kühlendne Bauelement und Kühlkörper über Durchkontaktierungen bzw. Thermal vias und einem Einsatz z.B. von Federblechen zum Anpressen der zu kühlenden Bauelemente zum Einhalten der notwendigen bzw. vorgegebenen Spannungsabstände relativ große Abstände bei der Anordnung der zu kühlenden Bauelemente auf der Trägerplatte sowie zusätzliche Isolierungsfolien und/oder Isolierelemente zum Vergrößern der Spannungsabstände notwendig. Dies führt neben einem höheren Platzbedarf für die Schaltung auch zu einer relativ zeitaufwendigen und komplexen Montage des elektrischen Geräts, welche weitgehend manuell durchgeführt werden muss.

### Darstellung der Erfindung

Der Erfindung liegt daher die Aufgabe zugrunde, ein Verfahren für eine Montage eines auf einer Trägerplatte angeordneten elektrischen Geräts mit zumindest einem zu kühlenden Bauelement anzugeben, welches zeit- und/oder kosteneffizient durchführbar ist und zumindest teilweise eine Automatisierung der Montage des elektrischen Geräts ermöglicht.

Diese Aufgabe wird durch ein Verfahren der eingangs beschriebenen Art mit den Merkmalen des unabhängigen Anspruchs gelöst. Vorteilhafte Ausführungsformen der vorliegenden Erfindung sind in den abhängigen Ansprüchen beschrieben.

Erfindungsgemäß erfolgt die Lösung der Aufgabe durch ein Verfahren der eingangs beschriebenen Art für eine Montage eines elektrischen Geräts, insbesondere eines Schaltnetzteils oder einer leistungselektronischen Schaltung. Das elektrische Gerät ist dabei aus Bauelementen und/oder Bauelementgruppen aufgebaut, welche die Schaltung für das elektrische Gerät bilden und auf einer Trägerplatte bzw. Leiterplatte angebracht sind. Von zumindest einem Bauelement des elektrischen Geräts wird eine Verlustleistung in Form von Wärme produziert, welche über eine thermische Verbindung zu einem Kühlkörper abgeleitet wird. Bei der Montage des auf der Trägerplatte angebrachten elektrischen Geräts werden dabei zumindest folgende Schritte durchlaufen:
a. Bereitstellen von zumindest dem Kühlkörper mit zumindest einem vormontierten Befestigungskörper zum Anbringen zumindest eines Anpresselements und einer Isolierung mit zumindest einer Isolierhülse, wobei eine Position des zumindest einen Befestigungskörpers auf dem Kühlkörper sowie eine Position der zumindest einen Isolierhülse auf der Isolierung durch eine Position des zumindest einen zu kühlenden Bauelements auf der Trägerplatte vorgegeben werden;
b. Anbringen der Isolierung auf dem Kühlkörper derart, dass der zumindest eine Befestigungskörper in die zumindest eine Isolierhülse der Isolierung eingefügt wird;
c. Anbringen der Trägerplatte des Geräts mit dem zumindest einen zu kühlenden Bauelement auf der Isolierung derart, dass der zumindest eine in die Isolierhülse eingefügte Befestigungskörper in einen Auslass in der Trägerplatte eingebracht wird, wobei eine Position des Auslasses in der Trägerplatte durch die Position des zumindest einen zu kühlenden Bauelements auf der Trägerplatte vorgegeben wird;
d. Anbringen des Anpresselements auf dem zumindest einen Befestigungskörper des Kühlkörpers; und
e. Verbinden des Anpresselements mit dem zumindest einen Befestigungskörper derart, dass das zumindest eine zu kühlende Bauelement über die Trägerplatte und die Isolierung mit dem Kühlkörper verspannt wird.

Der Hauptaspekt der erfindungsgemäß vorgeschlagenen Lösung besteht darin, dass das erfindungsgemäße Verfahren zumindest teilweise - vor allem die Verfahrensschritt b), c) und d) - sehr einfach automatisiert durchgeführt werden können. Die Ausgestaltung des Kühlkörpers mit vormontiertem Befestigungskörper wie der Isolierung mit Isolierhülse für den Befestigungskörper ermöglichen ein einfaches Ausrichten und Fügen dieser Einheiten. Weiterhin kann die Trägerplatte mit der Schaltung des elektrischen Geräts ebenfalls sehr einfach automatisiert positioniert angebracht werden, da der zumindest eine Befestigungskörper in den entsprechenden Auslass in der Trägerplatte eingebracht werden muss. Die Montage des elektrischen Geräts kann damit zeit- und kosteneffizient durchgeführt werden.

Weiterhin ermöglicht das erfindungsgemäße Montageverfahren, dass insbesondere durch das eingesetzte Anpresselement die zu kühlenden Bauelemente optimal an den Kühlkörper gepresst werden. Gleichzeitig wird dabei eine engere und platzsparendere Bauelementanordnung auf Trägerplatte ermöglicht. Dies ist insbesondere möglich, wenn das Anpresselement zum Anpressen von zumindest einen zu kühlenden Bauelement beispielsweise eine Ausführungsform aufweist, welche in der bisher unveröffentlichten europäischen Patentanmeldung EP 18196828.0 beschrieben wird. Dabei ist das Anpresselement idealerweise als Kunststoffspritzgussteil, insbesondere aus einem Hochleistungskunststoff (z.B. Polythermid bzw. PEI, Polyamidimid bzw. PAI), ausgeführt, wodurch einerseits keine ungewollten elektrischen und/oder elektromagnetischen Effekte bzw. EMV-Auswirkung beim Betrieb des elektrischen Geräts auftreten und andererseits eine federnde Wirkung bzw. eine Anpresskraft auf das zumindest eine zu kühlende Bauelement durch das Anpresselements über einen weiten Temperaturbereich gewährleistet ist.

Es ist vorteilhaft, wenn weiterhin das elektrische Gerät nach dem Verbinden des Anpresselements mit dem zumindest einen Befestigungskörper z.B. in einem Endmontageschritt in ein Gehäuse eingeschoben wird. Das mit dem Kühlkörper und der Isolierung zusammengefügte elektrische Gerät kann sehr einfach - gegebenenfalls automatisiert - im Gehäuse angeordnet werden. Weiterhin ist es denkbar, dass abschließend z.B. eine Gehäusefrontplatte bzw. -abdeckung sowie eine Befestigungsvorrichtung an der Gehäuserückwand angebracht werden.

Idealerweise wird vor dem Zusammenfügen der Trägerplatte mit dem elektrischen Gerät und dem zumindest einen zu kühlenden Bauelement mit der Isolierung eine Wärmeleitpaste verwendet, um eine Wärmeleitfähigkeit zu verbessern. Eine Zusammensetzung der verwendeten Wärmeleitpaste ist beispielsweise abhängig von der Wärmeleitfähigkeit, einem Anwendungsfall und einem Dauerbetriebstemperaturbereich der Wärmeleitpaste. Üblicherweise enthalten Wärmeleitpasten hauptsächlich Silikonöl und Zinkoxid, oder gegebenenfalls Aluminium-, Kupfer-, Graphit- und Silberbestandteile. Weiterhin können durch die Wärmeleitpaste auch kleine Oberflächenunebenheiten ausgeglichen werden. Die Wärmeleitpaste kann dabei entweder auf einer der Isolierung zugewandten Seite der Trägerplatte oder auf einer Oberseite und/oder Unterseite der Isolierung angebracht werden.

Bei einer bevorzugten Fortbildung des erfindungsgemäßen Verfahrens ist vorgesehen, dass nach Anbringen der Isolierung auf dem Kühlkörper oder in einer Vorbereitungsphase zumindest ein Isolierelement in einen entsprechenden Auslass in der Isolierung eingepasst wird. Eine Position des entsprechenden Auslasses in der Isolierung zum Anbringen des zumindest einen Isolierelements ist durch die Position des zumindest einen zu kühlenden Bauelements auf der Trägerplatte vorgegeben. D.h. die Position der Anbringung des jeweiligen Isolierelements in der Isolierung wird derart gewählt, dass das jeweilige Isolierelement im Bereich einer Durchkontaktierung bzw. im Kühlbereich des jeweiligen zu kühlenden Bauelements angeordnet ist.

Vom Isolierelement wird für eine zusätzliche und verbesserte galvanische Trennung zwischen den leitenden Teilen des Bauelements bzw. Durchkontaktierungen des Bauelements und dem metallischen Kühlkörper gesorgt. Idealerweise wird das Isolierelement derart ausgestaltet, dass ein vorgegebener Spannungsabstand zwischen dem Kühlkörper und dem zumindest einen zu kühlenden Bauelement eingehalten wird. Dazu kann das Isolierelement beispielsweise an die Form des zu kühlenden Bauelements bzw. der entsprechenden Durchkontaktierung der Trägerplatte angepasst werden und z.B. rechteckig oder quadratisch ausgeführt sein.

Seitenkanten des Isolierelements können idealerweise stufenförmig ausgeführt werden, wobei z.B. bei einer Betrachtung eines Querschnitts des Isolierelements eine mittlere Stufe über eine der Trägerplatte zugewandte und eine dem Kühlkörper zugewandte Stufe hervorspringt. Dadurch kann das Isolierelement sehr einfach in den Auslass in der Isolierung eingepasst werden. Weiterhin wird dadurch der vorgegebene Spannungsabstand bzw. der notwendige Mindestabstand für die Kriechstrecke zwischen dem zu kühlenden Bauelement und dem Kühlkörper auf einfache Weise eingehalten. Weiterhin ist die einfache Form des Isolierelement auch gut für eine automatisierte Handhabung verwendbar.

Weiterhin kann das Isolierelement neben der galvanischen Trennung für eine Weiterleitung von Wärme an den Kühlkörper eingesetzt werden. Das Isolierelement ist dazu idealerweise als Keramik-Pressteil ausgeführt sein und weist damit eine gute Wärmeleitfähigkeit sowie günstige Isoliereigenschaften auf. Es ist dabei weiterhin günstig, wenn am zumindest einen Isolierelement vor einem Einfügen in den entsprechenden Auslass in der Isolierung an einer Ober- und/oder Unterseite des Isolierelements eine Wärmeleitpaste angebracht wird. Dabei kann beispielsweise als Wärmeleitpaste ein so genanntes Phasenwechselmaterial oder Phase-change Material verwendet werden, welches z.B. vor dem Anbringen der Isolierelemente in den entsprechenden Auslässen auf die Isolierelemente aufgeschmolzen wird.

Weiterhin empfiehlt sich, dass die Isolierung als Kunststoffspritzgussteil, idealerweise plattenförmig ausgeführt ist. Die zumindest einer Isolierhülse für den zumindest einen Befestigungskörper am Kühlkörper kann dabei integriert sein. Durch die Ausführung als Spritzgussteil kann die Isolierung sehr einfach und leicht an das entsprechende elektrische Gerät (z.B. Größe, Bedarf an Isolierhülsen, etc.) angepasst werden. Als Material kann z.B. Polykarbonat verwendet werden, welches gute Isoliereigenschaften für eine galvanische Trennung zwischen Trägerplatte und metallischen Kühlkörper sowie eine entsprechende Spannungsfestigkeit und Wärmeleitfähigkeit aufweist.

Eine zweckmäßige Ausgestaltung des erfindungsgemäßen Verfahrens sieht vor, dass der Kühlkörper als Aufbauplattform für das elektrische Gerät eingesetzt wird. Der Kühlkörper kann dazu z.B. im einfachsten Fall als Aluminiumplatte ausgestaltet sein, auf welcher der zumindest eine bzw. die Befestigungskörper an den durch die zu kühlenden Bauelemente vorgegebenen Positionen vormontiert sind. Die Befestigungskörper sind z.B. als Keramikelemente für eine verbesserte Wärmeübertragung ausgeführt.

Es ist weiterhin günstig, wenn der zumindest eine Befestigungskörper als Befestigungsdom, insbesondere als Schraubdom, ausgestaltet ist. Das Anpresselement wird dann mittels eines Befestigungsmittels - idealerweise einer Schraube - mit dem Befestigungskörper verbunden. Durch diese Verbindung wird dann das zu kühlende Bauelement über die Trägerplatte und die Isolierung bzw. das zugehörige Isolierelement an den Kühlkörper gepresst.

### Kurzbeschreibung der Zeichnung

Die Erfindung wird nachfolgend in beispielhafter Weise anhand der beigefügten Figuren erläutert. Dabei zeigen:
- Figur 1: einen beispielhaften Ablauf des erfindungsgemäßen Verfahren zur Montage eines elektrischen Geräts anhand zu montierender Einheiten
- Figur 2: schematisch einen beispielshaften Ausschnitt des elektrischen Geräts in einem Bereich eines zu kühlender Bauelemente in einem montierten Zustand nach Durchlaufen des erfindungsgemäßen Verfahrens

### Ausführung der Erfindung

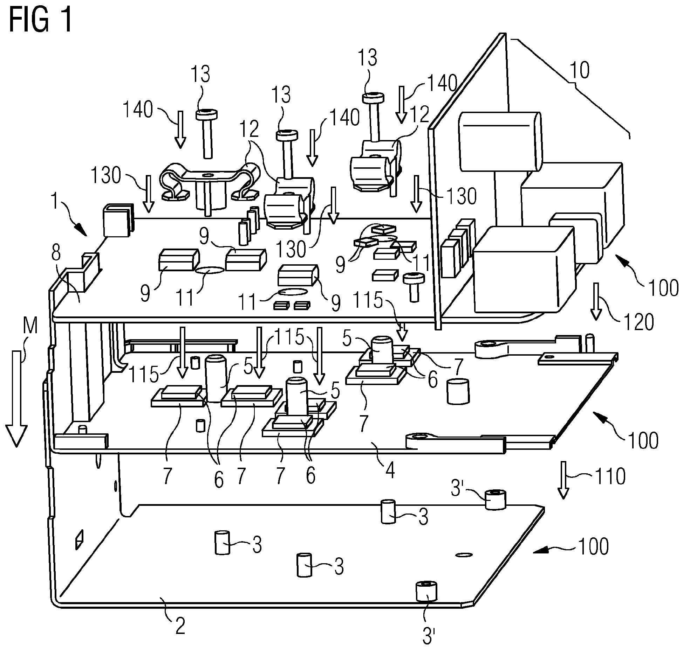

Figur 1 zeigt in schematischer Weise beispielhaft ein elektrisches Gerät 1, welches aus Bauelementen und Bauelementgruppen 9, 10 aufgebaut ist. Die Bauelemente und Bauelementgruppen 9, 10 sind auf einer Trägerplatte 8 angebracht. Dabei wird von zumindest einem Bauelement 9 während eines Betriebs des elektrischen Geräts 1 eine Verlustleistung in Form von Wärme produziert, welche über eine thermische Anbindung an einen Kühlkörper 2 abgeleitet werden muss.

Für das erfindungsgemäße Verfahren zur Montage des elektrischen Geräts 1 werden neben den elektrischen Gerät 1, dessen aus Bauelementen und/oder Bauelementgruppen 9, 10 bestehende Schaltung auf der Trägerplatte 8 angeordnet ist, in einem Bereitstellungsschritt 100 zumindest ein Kühlkörper 2 und eine Isolierung 4 bereitgestellt.

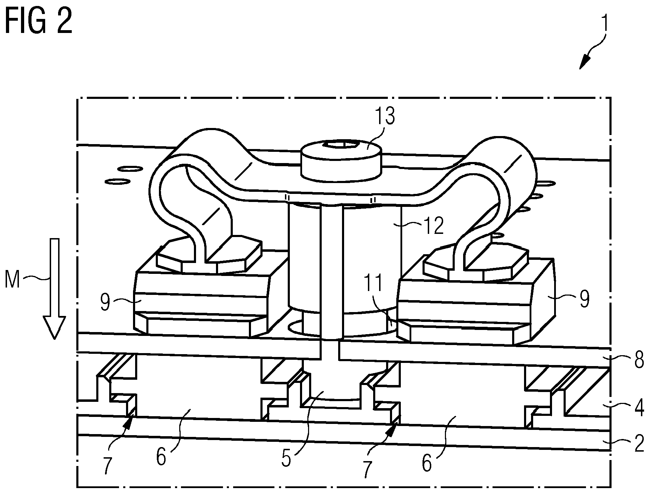

Der Kühlkörper 2 kann beispielsweise als Aufbauplattform für das fertigmontierte, elektrische Gerät 1 - wie beispielhaft in Figur 2 dargestellt - verwendet werden. Dazu ist der Kühlkörper 2 beispielsweise plattenförmig aus einem gut wärmeableitenden Metall z.B. aus Aluminium ausgeführt. Weiterhin weiset der Kühlkörper 2 zumindest einen Befestigungskörper 3 (z.B. aus Keramik für eine gute Wärmeleitung) auf, welcher am Kühlkörper vormontiert ist und für eine Befestigung von einem Anpresselement 12 dient. Die Position des zumindest einen vormontierten Befestigungskörpers wird durch ein Position des zumindest einen Wärme produzierenden Bauelements 9 des elektrischen Geräts 1 auf der Trägerplatte 8 vorgegeben. Der Kühlkörper 2 kann zusätzlich weitere Befestigungskörper 3' aufweisen, welche beispielweise zum zusätzlichen Verbinden und/oder Fixieren der Trägerplatte 8 in einem Bereich von z.B. größeren Bauelementen oder Bauelementgruppen 10 mit dem/am Kühlkörper 2 verwendet werden können.

Die Isolierung 4 ist beispielsweise ein Kunststoffspritzgussteil und kann z.B. plattenförmig ausgeführt sein. Als Material kann beispielsweise Polykarbonat verwendet werden, welches einerseits eine gute Wärmeleitung ermöglicht und anderseits gute Isoliereigenschaften aufweist. Weiterhin weist die Isolierung 4 zumindest eine Isolierhülse 5 auf, welche in die Isolierung 4 integriert sein kann. Die Position der zumindest einen Isolierhülse 5 wird ebenfalls durch die Position des zumindest einen zu kühlenden bzw. Wärme produzierenden Bauelements 9 vorgegeben. Alternativ kann die Isolierung 4 beispielsweise auch als Isolierfolie aus Silikon ausgestaltet sein bzw. es kann

In einem ersten Fügeschritt 110 wird dann die Isolierung 4 auf dem z.B. als Aufbauplattform dienenden Kühlkörper 2 angebracht. Dabei wird der zumindest einen Befestigungskörper 3 des Kühlkörpers 2 in die zumindest eine Isolierhülse 5 der Isolierung 4 eingefügt. D.h. die Positionierung der Isolierung 4 auf dem Kühlkörper 2 wird durch den zumindest einen Befestigungskörper 3 und die Isolierhülse 5 vorgegeben. Der erste Fügeschritt 110 kann damit sehr einfach automatisiert ausgeführt werden. Zusätzlich kann die Isolierung 4 beispielweise vor dem ersten Fügeschritt 110 auf einer dem Kühlkörper zugewandten Seite bzw. einer Unterseite in einer Montagerichtung M mit einer Wärmeleitpaste versehen werden. Alternativ kann vor dem Anbringen der Isolierung 4 im ersten Fügeschritt 110 zum Verdrängen von Lufteinschlüssen bzw., um das Entstehen von Wärmenestern zu verhindern, z.B. eine isolierende Folie aus Silikon zwischen Kühlkörper 2 und Isolierung 4 angebracht werden.

Dann ist es möglich, dass nach Anbringen der Isolierung 4 auf dem Kühlkörper 2 in einem Zwischenschritt 115 zumindest ein Isolierelement 6 in einen Auslass 7 in der Isolierung eingepasst wird. Die Position des Auslasses 7 wird dabei derart durch die Position des zumindest einen zu kühlenden Bauelement 9 auf der Trägerplatte 8 des elektrischen Geräts 1 vorgegeben, dass im montierten Zustand - wie in Figur 2 dargestellt - das zumindest eine Isolierelement 6 im Bereich einer Kontaktierung des jeweils zu kühlenden Bauelements 9 zum Liegen kommt.

Das Isolierelement 6 ist dazu derart ausgestaltet, dass zumindest ein vorgegebener Spannungsabstand - insbesondere eine einzuhaltende Mindestkriechstrecke - zwischen dem zu kühlenden Bauelement 9 bzw. den Leiterbahnen oder einer Kontaktierung des Bauelements 9 und dem Kühlkörper 2 eingehalten wird. Insbesondere kann das Isolierelement in seiner Form an die Kontaktierung des Bauelements 9 angepasst und weist z.B. eine quadratische oder rechteckige Form auf. Für eine gute wärmeleitende wie isolierende Wirkung wird das Isolierelement 6 z.B. als Keramikpressteil ausgeführt. Zusätzlich kann das Isolierelement 6 vor dem Einpassen in den entsprechenden Auslass 7 an einer Ober- und/oder Unterseite mit Wärmeleitpaste bzw. mit einem so genannten Phasenwechselmaterial für eine verbesserte Wärmeübertragung versehen werden. Zum leichteren - insbesondere automatisierten Einpassen des Isolierelements 6 - kann - wie insbesondere in Figur 2 ersichtlich - stufenförmig ausgebildete Seitenkanten aufweisen.

Alternativ kann das zumindest eine Isolierelement 6 auch in einem Vorbereitungsschritt vor dem Anbringen der Isolierung 4 im ersten Fügeschritt 110 in den entsprechenden Auslass 7 in der Isolierung 4 eingepasst werden. Die Isolierung 4 wird dann gemeinsam mit den eingepassten Isolierelementen 6 im ersten Fügeschritt 110 am Kühlkörper 2 angebracht.

In einem zweiten Fügeschritt 120 wird dann die Trägerplatte 8 mit der Schaltung des elektrischen Geräts 1 bzw. mit dem zumindest einen zu kühlenden Bauelement 9 auf dem mit der Isolierung 4 versehenen Kühlkörper 2 angebracht. Dabei wird die Trägerplatte 8 derart auf der Isolierung 4 positioniert, dass eingefügte Befestigungskörper 3 in einen Auslass 11 in der Trägerplatte 8 eingebracht wird. Der Auslass 11 in der Trägerplatte 8 weist dabei eine derartige Position auf, dass der isolierte Befestigungskörper 3 unter Einhaltung eines vorgegebenen Spannungsabstands - insbesondere einer vorgegebenen Luftstrecke - neben dem zumindest einen zu kühlenden Bauelement eingebracht wird. Wie in Figur 1 dargestellt ist der Auslass 11 in der Trägerplatte z.B. zwischen zwei zu kühlenden Bauelementen 9 angebracht. Nach dem zweiten Fügeschritt 120 befindet sich der jeweilige auf dem Kühlkörper vormontierte und isolierte Befestigungskörper 3 beispielsweise im Auslass 11 zwischen den zu kühlenden Bauelementen 9.

Dabei ist zu beachten, dass ein Abstand der Trägerplatte 8 von der Isolierung 4 einerseits von einzuhaltenden Kriechstrecken zwischen leitenden Teilen wie z.B. Durchkontaktierungen bzw. Kontaktierungen der Bauelemente 9, 10, einem Kühlkörper 2, Befestigungsmittel 13, etc. und andererseits gegebenenfalls von einem Platzbedarf von an einer der Isolierung 4 zugewandten Seite der Trägerplatte 8 angeordneten Bauelementen 10 abhängig. D.h. durch Isolierelemente 6 bzw. eine entsprechende Ausgestaltung der Isolierung 4 kann dieser Abstand zwischen Trägerplatte 8 und Isolierung 4 hergestellt werden.

Vor dem zweiten Fügeschritt 120 kann zusätzlich die der Isolierung 4 zugewandte Seite der Trägerplatte 8 mit Wärmeleitpaste versehen werden. Alternativ oder zusätzlich kann auch auf die der Trägerplatte 8 zugewandte Seite der Isolierung 4 (z.B. eine Oberseite der Isolierung 4 in Montagerichtung M) für eine verbesserte Wärmeübertragung mit Wärmeleitpaste versehen werden.

In einem dritten Fügeschritt 130 wird dann das Anpresselement 12 auf dem zumindest einen Befestigungskörper 3 angebracht, welcher in die Isolierhülse 5 eingefügt ist. Das Anpresselement ist dabei zumindest derart ausgestaltet, dass der isolierte Befestigungskörper 3 in das Anpresselement 12 eingefügt werden kann und dass das Anpresselement 12 zumindest ein Einrichtung zum Anpressen des zumindest einen zu kühlenden Bauelements 9 aufweist. Dabei ist es günstig, wenn das Anpresselement 12 derart ausgestaltet ist, wie in der bisher unveröffentlichten europäischen Patentanmeldung EP 18196828.0 beschrieben bzw. in Figur 1 dargestellt, und als Kunststoffspritzgussteil ausgeführt ist. Durch die Ausgestaltung als Kunststoffspritzgussteil - idealerweise aus einem Hochleistungskunststoff - (z.B. Polythermid bzw. PEI, Polyamidimid bzw. PAI) - verursacht das Anpresselement 12 keine ungewollten elektrischen und/oder elektromagnetischen Effekte bzw. EMV-Auswirkung und weist über einen weiten Temperaturbereich eine federnde Wirkung (d.h. das jeweilige zu kühlende Bauelement 9 mit dem entsprechenden Anpressdruck über einen weiten Temperaturbereich vom Anpresselemente 12) gegen den Kühlkörper 2 gedrückt) auf.

In einem Befestigungsschritt 140 wird dann das Anpresselement 12 mit dem zumindest einen in die entsprechende Isolierhülse 5 eingefügten Befestigungskörper 3 verbunden und dadurch das zumindest eine zu kühlende Bauelement 9 über die Trägerplatte 8 und die Isolierung 4 bzw. das entsprechende Isolierelement 6 an den Kühlkörper 2 angepresst. Der Befestigungskörper 3 kann dazu beispielsweise als Befestigungsdom, insbesondere als Schraubdom mit einem Innengewinde, ausgeführt sein. Im Befestigungsschritt 140 wird dann z.B. in einen Auslass im Anpresselement 12 ein Befestigungsmittel 13, insbesondere eine Schraube, eingebracht und mit dem Befestigungskörper 3 verbunden. Durch das Fixieren des Anpresselements 12 am Befestigungskörper 3 wird dann vom Anpresselement 12 ein Druck auf das zumindest eine zu kühlende Bauelement 9 ausgeübt und dieses gegen die Trägerplatte 8 und damit auch gegen den Kühlkörper 2 gedrückt. Als Befestigungsmittel 13 kann alternativ zu einer Schraube auch eine Niete eingesetzt werden. Weiterhin sind zum Befestigen des Anpressmittel 12 am Befestigungskörper 3 und zum Anpressen des Bauelements 9 auch mechanische Verbindung wie z.B. eine Schnappverbindung oder eine Presspassung denkbar.

Nach Durchlaufen der Montageschritte des erfindungsgemäßen Verfahrens, insbesondere der Fügeschritte 110, 120, 130 und dem Befestigungsschritt 140, z.B. in einer automatisierten Fertigungsstrecke kann in einem zusätzlichen Endmontageschritt 150 das elektrische Gerät 1 in ein Gehäuse eingeschoben werden. Danach kann das Gehäuse z.B. mit einer Frontplatte, in welcher z.B. Auslässe für Anzeige- und/oder Bedienelemente verfügbar sind, verschlossen werden. An einer Gehäuserückwand kann z.B. weiterhin eine Befestigungs- und Rastvorrichtung montiert werden, um das elektrische Gerät 1 für einen Betrieb beispielweise in einem Geräteschrank und/oder an einer Hutschiene anzubringen.

Figur 2 zeigt schematisch einen beispielhaften Ausschnitt des elektrischen Geräts 1 im Bereich zu kühlender Bauelemente 8, nachdem die in Figur 1 dargestellten Einheiten - Kühlkörper 2, Isolierung 4, Trägerplatte 8 mit den Bauelementen 9, 10, Anpresselemente 12, etc. - mit Hilfe des erfindungsgemäßen Verfahrens zusammengefügt worden sind.

Auf der Trägerplatte 8 sind die zu kühlenden Bauelemente 9 - neben weiteren Bauelemente und Bauelementgruppen 10, welche in Figur 2 nicht dargestellt sind - angebracht. Im montierten Zustand ist der im Bereitstellungsschritt 100 bereitgestellte Kühlkörper 2, von welchem die Aufbauplattform für das elektrische Gerät 1 gebildet wird, an einer zumindest im Bereich der zu kühlenden Bauelemente 9 bzw. im Kühlbereich nicht bestückten Seite der Trägerplatte 8 bzw. einer in Montagerichtung M Unterseite der Trägerplatte 8 angeordnet. Der am Kühlkörper zumindest eine vormontierte Befestigungskörper 3 - in Figur 2 nicht sichtbar - ist dabei aufgrund des ersten Fügeschritts 110 in die Isolierhülse 5 der Isolierung 4 eingefügt. In der Trägerplatte 8 ist z.B. zwischen zu kühlenden Bauelementen 9 der Auslass 11 vorgesehen, in welchen der in die Isolierhülse 5 eingefügte Befestigungskörper 3 im zweiten Fügeschritt 120 eingebracht wurde.

Zwischen dem Kühlkörper 2 und der Trägerplatte 8 ist die im ersten Fügeschritt 110 angebrachte Isolierung 4 angeordnet. Für eine zusätzliche galvanische Trennung der Trägerplatte 8 bzw. der Kontakte, insbesondere einer Durchkontaktierungen, der Bauelemente 9 vom Kühlkörper 2, welcher aus Metall, insbesondere Aluminium, ausgeführt sein kann, können im Kontaktierungsbereich der zu kühlenden Bauelemente 9 Isolierungselemente 6 angeordnet sein. Diese Isolierungselemente 6 können beispielsweise im zusätzlichen Zwischenschritt 115 vor dem zweiten Fügeschritt 120 oder in einem Vorbereitungsschritt in die entsprechenden Auslässe 7 der Isolierung 4 formbündig eingepasst werden.

Nach dem zweiten Fügeschritt 120, in welchem die Trägerplatte 8 mit der Schaltung des elektrischen Geräts 1 angebracht wurde, werden im dritten Fügeschritt 130 die Anpresselemente 12 auf den Befestigungskörpern 3 angebracht. Dabei wird z.B. das Anpresselemente 12 in den Auslass 11 der Trägerplatte 8 in der Montagerichtung M eingebracht, aus welchem entgegen der Montagerichtung M der isolierte Befestigungskörper 3 bzw. zumindest die zugehörig Isolierhülse 5 ragt. Dabei kommen z.B.

Einrichtungen zum Anpressen der Bauelemente 9 (z.B. Federarme bzw. zugehörige Auflageflächen) des Anpresselements 12 auf den zu kühlenden Bauelementen 9 zum Liegen und ein Mittelteil des Anpresselements 12 nimmt den in die Isolierhülse 5 eingefügten Befestigungskörper 3 auf.

Im Befestigungsschritt 140 wird dann z.B. in einen Auslass an der oberen Seite des Anpresselements 12 ein Befestigungsmittel 13, insbesondere eine Schraube oder Niete, in Montagerichtung M eingefügt. Das Befestigungsmittel 13 ist dann im montierten Zustand mit dem Befestigungskörper 3 derart verbunden, dass das Anpresselement 12 z.B. über seine Auflageflächen eine Anpresskraft auf die zu kühlenden Bauelemente 9 überträgt. D.h. die Bauelemente 9 werden nach Fixierung des Anpresselements 12 gegen die Trägerplatte 8 und damit gegen den Kühlkörper 2 gepresst.

Nach Durchlaufen der Montageschritte des erfindungsgemäßen Verfahrens, insbesondere der Fügeschritte 110, 120, 130 und dem Befestigungsschritt 140, z.B. in einer automatisierten Fertigungsstrecke kann das fertig montierte, elektrische Gerät 1 im Endmontageschritt 150 in ein Gehäuse eingeschoben werden. Das Gehäuse kann dann beispielsweise verschlossen und mit einer Befestigungsvorrichtung versehen werden. Das im Gehäuse angebrachte elektrische Gerät 1 kann dann z.B. in einem Schaltschrank und/oder an einer Schiene montiert werden.

### Bezugszeichenliste

- 1: elektrische Gerät
- 2: Kühlkörper
- 3, 3': Befestigungskörper
- 4: Isolierung
- 5: Isolierhülse für Befestigungskörper
- 6: Isolierelement
- 7: Auslass in der Isolierung
- 8: Trägerplatte bzw. Leiterplatte
- 9: zu kühlende Bauelemente
- 10: weitere Bauelemente, Bauelementgruppen
- 11: Auslass in der Träger- bzw. Leiterplatte
- 12: Anpresselement
- 13: Befestigungsmittel
- M: Montagerichtung

- 100: Bereitstellungsschritt
- 110: erster Fügeschritt
- 115: Zwischenschritt zum Einpassen der Isolierelementen
- 120: zweiter Fügeschritt
- 130: dritter Fügeschritt
- 140: Befestigungsschritt
- 150: Endmontageschritt

## Patentansprüche

1. Verfahren zur Montage eines elektrischen Geräts (1), welches aus auf einer Trägerplatte (8) angebrachten Bauelementen und/oder Bauelementgruppen (9, 10) aufgebaut ist, wobei von zumindest einem Bauelement (9) eine Verlustleistung produziert wird, welche über eine thermische Verbindung zu einem Kühlkörper (2) abgeleitet wird, mit zumindest den folgenden Schritten:
a. Bereitstellen zumindest des Kühlkörper (2) mit zumindest einem vormontierten Befestigungskörper (3) zum Anbringen zumindest eines Anpresselements (12) und einer Isolierung (4) mit zumindest einer Isolierhülse (5), wobei eine Position des zumindest einen Befestigungskörpers (3) auf dem Kühlkörper (2) sowie eine Position der zumindest einen Isolierhülse (5) auf der Isolierung (4) durch eine Position des zumindest einen zu kühlenden Bauelements (9) auf der Trägerplatte (8) vorgegeben werden (100);
b. Anbringen der Isolierung (4) auf dem Kühlkörper (2) derart, dass der zumindest eine Befestigungskörper (3) in die zumindest eine Isolierhülse (5) der Isolierung (4) eingefügt wird (110);
c. Anbringen der Trägerplatte (8) des Geräts (1) mit dem zumindest einen zu kühlenden Bauelement (9) auf der Isolierung (4) derart, dass der zumindest eine in die Isolierhülse (5) eingefügte Befestigungskörper (3) in einen Auslass (11) in der Trägerplatte (8) eingebracht wird (120), wobei eine Position des Auslasses (11) in der Trägerplatte (8) durch die Position des zumindest einen zu kühlenden Bauelements (9) auf der Trägerplatte (8) vorgegeben wird;
d. Anbringen des Anpresselements (12) auf dem zumindest einen Befestigungskörper (3) des Kühlkörpers (2), (130); und
e. Verbinden des Anpresselements (12) mit dem zumindest einen Befestigungskörper (3) derart (140), dass das zumindest eine zu kühlende Bauelement (9) über die Trägerplatte (8) und die Isolierung (4) mit dem Kühlkörper (2) verspannt wird.

2. Verfahren nach Anspruch 1, ***dadurch gekennzeichnet, dass*** weiterhin das elektrische Gerät (1) nach dem Verbinden des Anpresselements (12) mit dem zumindest einen Befestigungskörper (3) in ein Gehäuse eingeschoben wird (150).

3. Verfahren nach einem der vorabgegangenen Ansprüche, ***dadurch gekennzeichnet, dass*** vor dem Anbringen der Trägerplatte (8) auf der Isolierung (4) eine Wärmeleitpaste entweder auf eine der Isolierung (4) zugewandten Seite der Trägerplatte (8) oder einer Oberseite und/oder Unterseite der Isolierung (4) aufgebracht wird.

4. Verfahren nach einem der vorangegangenen Ansprüche, **da*durch gekennzeichnet, dass*** nach Anbringen der Isolierung (4) auf dem Kühlkörper (2) oder in einer Vorbereitungsphase zumindest ein Isolierelement (6) in einen entsprechenden Auslass (7) in der Isolierung (4) eingepasst wird (115), wobei eine Position des zumindest eine Auslasses (7) in der Isolierung (4) durch die Position des zumindest einen zu kühlenden Bauelements (9) vorgegeben wird.

5. Verfahren nach Anspruch 4, ***dadurch gekennzeichnet, dass*** das zumindest eine Isolierelement (6) derart ausgestaltet ist, dass ein vorgegebener Spannungsabstand zwischen dem Kühlkörper (2) und dem zumindest einen zu kühlenden Bauelement (9) eingehalten wird.

6. Verfahren nach einem der Ansprüche 4 und 5, ***dadurch gekennzeichnet, dass*** bei dem zumindest einen Isolierelement (6) stufenförmig ausgestaltete Seitenkanten derart vorgesehen werden, dass das zumindest eine Isolierelement (6) in den entsprechend gestalteten Auslass (7) der Isolierung (4) formbündig eingepasst werden kann.

7. Verfahren nach einem der Ansprüche 4 bis 6, ***dadurch gekennzeichnet, dass*** das zumindest eine Isolierelement (6) als Keramik-Pressteil ausgeführt wird.

8. Verfahren nach einem der Ansprüche 4 bis 7, ***dadurch gekennzeichnet, dass*** am zumindest einen Isolierelement (6) vor einem Einfügen in den entsprechenden Auslass (7) in der Isolierung (4) an einer Ober- und/oder Unterseite des Isolierelements (6) eine Wärmeleitpaste angebracht wird (115) .

9. Verfahren nach einem der vorangegangenen Ansprüche, ***dadurch gekennzeichnet, dass*** die Isolierung (4) plattenförmig als Kunststoffspritzgussteil mit zumindest einer integrierter Isolierhülse (5) für den zumindest einen Befestigungskörper (3) ausgeführt ist.

10. Verfahren nach einem der vorangegangenen Ansprüche, ***dadurch gekennzeichnet, dass*** der Kühlkörper (2) als Aufbauplattform für das elektrische Gerät eingesetzt wird.

11. Verfahren nach einem der vorangegangenen Ansprüche, ***dadurch gekennzeichnet, dass*** der zumindest eine Befestigungskörper (3) als Befestigungsdom, insbesondere als Schraubdom, ausgestaltet ist, und dass das Anpresselement (12) mittels eines Befestigungsmittels (13), insbesondere einer Schraube, mit dem zumindest einen Befestigungskörper (3) verbunden wird (140).
